# EUROPEAN PATENT APPLICATION

(11) **EP 4 033 004 A1**
(43) Date of publication of application: **27.07.2022**
(21) Application number: 20865240.4
(22) Date of filing: 01.04.2020
(51) Int. Cl.: C23C 16/50, C23C 16/458

(54) **COATING APPARATUS, MOVING ELECTRODE DEVICE AND MOVABLE SUPPORT DEVICE THEREFOR, AND USE THEREOF**

(30) Priority: 20.09.2019 CN 201910893117; 20.09.2019 CN 201910893933
(71) Applicant: Jiangsu Favored Nanotechnology Co., Ltd., Yuqi Industry Park, Huishan District Wuxi Jiangsu 214000 (CN)
(72) Inventor: ZONG, Jian, Wuxi, Jiangsu 214112 (CN)
(74) Representative: Mewburn Ellis LLP
(86) International application number: PCT/CN2020/082798
(87) International publication number: WO 2021/051779

(57) **Abstract**

Provided are a coating apparatus, a moving electrode device and a movable support device therefor, and a use thereof. The coating apparatus comprises a reaction cavity body and a movable support device, wherein the reaction cavity body is provided with a reaction cavity, the movable support device is contained in the reaction cavity, the movable support device comprises at least one electrode and a movable support, the movable support is movable relative to the reaction cavity body, at least one electrode is arranged on the movable support in a manner of being able to move along with the movable support, and at least one workpiece to be coated is suitable for being held on the movable support so as to move along with the movable support.

## Description

### TECHNICAL FIELD

The present disclosure relates to the coating field, and more particularly, to a coating apparatus, a movable electrode device and a movable support device therefor, and application.

### BACKGROUND

Coatings can protect the material's surface and bring about good physical and chemical durability of the material. Some coatings such as polymer coatings have certain anti-corrosion properties, which can be used to form a protective film layer on the surface of electronic components such as electronic appliances and circuit boards, and effectively protect circuits from corrosion and damage in corrosive environments, thereby improving reliability of electronic components.

In the process of forming a coating, a workpiece to be coated needs to be placed in a reaction chamber, and a reactant gas needs to be introduced. Under the action of plasma, reactant gas is chemically vapor deposited on the surface of the workpiece to be coated to form a coating. In this process, it is necessary to continuously evacuate the chamber so that the exhaust gas generated by the continuous reaction of reactive materials on the surface of the workpiece can be removed, so as to maintain stable coating pressure conditions. However, it is notable that, when the reactant gas is introduced into the feeding inlet, the reaction raw materials tend to accumulate near the feeding inlet, resulting in a high gas concentration at the feeding inlet, however, the gas concentration at the exhausting outlet is low. Therefore, there is different concentration of reactant gas in the reaction chamber, which is easy to cause uneven nano coatings in thickness on the workpiece to be coated at different positions in the reaction chamber. At present, some manufacturers in the industry use a rotating stage to solve this problem, where the stage is used to carry the workpiece to be coated. The stage can be rotated relative to the reaction chamber to act as a role of stirring, which is conducive to the uniformity concentration of the reactant gas.

In conventional coating apparatus, generally there are two types of plasma coating methods according to whether the workpiece is placed between electrodes or not. One is to place the workpiece to be coated directly between the electrode plates (in the electric field), the electrode plates are fixedly configured in the reaction chamber by two or more opposite electrodes, and one electrode plate of each pair of electrodes is coupled to the high-frequency power supply, the other opposite electrode plate of the pair of electrodes is grounded or coupled to the other pole of the power supply. When the power supply is turned on, an electric field is generated between the pair of electrode plates and the gaseous raw materials configured therebetween are activated to form plasma. Generally speaking, most of the large-scale industrial manufacturing devices adopt parallel plate electrodes, which are stable in discharge with high efficiency, and a large area of processing capacity can be obtained. However, in practical application, it is found that because the plasma energy between the electrodes is generally large, the surface of the workpiece placed between the electrodes is directly bombarded, which is likely to cause damage to the surface of the workpiece. Typical screens of electronic products, such as mobile phones, electronic watches, PADs, etc., are often pre-processed with anti-fingerprint treatment, and the surface has a thin layer of anti-fingerprint coating. This layer of coating is easy to be damaged under the bombardment of the plasma, resulting in a loss of anti-fingerprint effect.

Another plasma coating method is to place the workpiece outside the electrode, and the activated reactive raw material (containing plasma) diffuses to the surface of the workpiece, to form a protective coating through a deposition reaction. Since the workpiece is not directly placed between the electrode plates, the energy of the plasma is continuously attenuated with the movement of the plasma leaving the electric field area. The energy of the plasma is already relatively low when it reaches the surface of the workpiece, compared with the previous solution, the electrodes have weak bombardment effect on the workpiece surface. However, it is also found in practical applications that electrodes with this setup leads to a slow deposition rate, and some monomers requiring high-energy plasma activation cannot be effectively excited into plasma state, which limits their application. In addition, a relative position between the electrode and the reaction chamber of most of the current plasma coating devices on the market is fixed, and the discharge position of the electrode is fixed, where a fixed discharge environment is provided in the reaction chamber. However, when the stage rotates, the discharge of the electrode may be affected by the stage, and the rotating stage may act as a shielding role, which may finally affect the yield of the product.

Chinese patent application CN206775813 discloses a plasma-initiated polymerization device with a stator & rotor electrode group. In the device, fixed metal straight rods are fixedly coupled with the inner wall of the vacuum chamber at equal intervals along the axial direction of the vacuum chamber through an insulating base, and fixed metal straight rods are connected in series through wires to form a fixed electrode. Rotating metal straight rods are fixedly coupled with a metal movable support at equal intervals along the axial direction of the vacuum chamber to form a rotating electrode. The fixed electrode is coupled to the output terminal of the high-frequency power supply, and the rotating electrode is grounded. During operation, the high-frequency power supply is turned on to continuously input high-frequency power and the rotating electrode is rotated. The rotating electrode periodically approaches and leaves the fixed electrode, resulting in a plasma that annihilates periodically. The advantage of this device is that through contact discharge, the effect of periodic interval discharge can be achieved without pulse modulation. In this device, the rotating electrode remains relatively stationary relative to the substrate, and the plasma is redeposited on the surface of the substrate by diffusion to form a polymer coating. However, there is still a gradient problem in the plasma concentration at different spatial positions.

### SUMMARY

An advantage of the present disclosure is to provide a coating apparatus, a movable electrode device and a movable support device therefor, and application. Wherein, one or more electrodes of the coating apparatus can rotate to provide a relatively uniform discharge environment in the reaction chamber of the coating apparatus.

Another advantage of the present disclosure is to provide a coating apparatus, a movable electrode device and a movable support device therefor, and application. Wherein, the electrode of the coating apparatus can discharge toward the workpiece to be coated on a movable support that can rotate, that is, the rotating electrode is adapted to discharge toward the movable workpiece to be coated, so as to improve the uniformity of the coating.

Another advantage of the present disclosure is to provide a coating apparatus, a movable electrode device and a movable support device therefor, and application. Wherein, compared with the electrode fixedly configured in the conventional coating setting, the electrode of the coating apparatus of the present disclosure can rotate with the movable support. A stage used to carry the workpiece to be coated is also rotatable around its central axis when rotating with the movable support. Thus, the relative movement between the electrode of the coating apparatus and the workpiece to be coated is caused by the rotation of the stage along its central axis, so that the electrode provides a relatively uniform discharge environment for the workpiece to be coated.

Another advantage of the present disclosure is to provide a coating apparatus, a movable electrode device and a movable support device therefor, and application. Wherein, the workpiece to be coated in the coating apparatus can move relatively to the electrode, so that the workpiece to be coated can be placed between the opposite electrodes or away from the inner area of the opposite electrodes during the coating process, which may avoid the workpiece being damaged due to being configured in the inner area of the electrode for a long time.

Another advantage of the present disclosure is to provide a coating apparatus, a movable electrode device and a movable support device therefor, and application. Wherein, the workpiece to be coated in the coating apparatus can move relatively to the electrode, so that the workpiece to be coated can be placed between the opposite electrodes or away from the inner area of the opposite electrodes during the coating process, which may avoid the problem of slow deposition speed caused by plasma deposition only by diffusion on the surface of the workpiece to be coated.

Another advantage of the present disclosure is to provide a coating apparatus, a movable electrode device and a movable support device therefor, and application. Wherein, comparing to the electrodes fixedly configured on the chamber wall as described in the conventional coating setting, electrodes of the coating apparatus of the present disclosure is closer to the workpiece to be coated on the stage.

Another advantage of the present disclosure is to provide a coating apparatus, a movable electrode device and a movable support device therefor, and application. Wherein, electrodes of the movable support device are movable, the movable electrodes can not only result in uniform coatings, but also result in a part of the raw gas for the coating being fully ionized when passing through the discharge area, and a part of the raw gas for the coating which does not pass through the discharge area of the electrodes not fully ionized. In this way, rich coating structure and stable coating quality can be obtained through raw materials without ionized state which can be obtained by adjusting coating parameters.

Another advantage of the present disclosure is to provide a coating apparatus, a movable electrode device and a movable support device therefor, and application. Wherein, the relative position between the electrode and the movable support is fixed, and the movable support of the coating apparatus may not interfere with the discharge of the electrode.

According to an aspect of the present disclosure, the present disclosure provides a coating apparatus, which includes:
a reaction chamber body, wherein the reaction chamber body is provided with a reaction chamber;
a pumping device, communicated with the reaction chamber body;
a feeding device, wherein the reaction chamber body has a feeding inlet, the feeding inlet is communicated with the reaction chamber, the feeding device is communicated with the feeding inlet; and
a movable support device, configured in the reaction chamber, wherein the movable support device includes at least one electrode and a movable support, the movable support is movable relative to the reaction chamber body, the at least one electrode is configured on the movable support in a manner of being able to move along with the movable support, and the movable support is adapted to hold at least one workpiece to be coated which can move along with the movable support.

According to at least one embodiment of the present disclosure, the at least one electrode is configured in a circumferential direction of the movable support.

According to at least one embodiment of the present disclosure, the at least one electrode has a discharge surface, wherein the discharge surface is configured with an orientation toward a central axis of the movable support.

According to at least one embodiment of the present disclosure, the at least one electrode has a discharge surface, wherein the discharge surface is configured with an orientation toward a workpiece to be coated.

According to at least one embodiment of the present disclosure, the at least one electrode is configured in a radial direction of the movable support.

According to at least one embodiment of the present disclosure, the coating apparatus further includes at least one stage configured on the movable support, wherein the stage is adapted for holding the workpiece to be coated and the stage is configured on the movable support in a manner of being able to move relatively to the movable support, so that the electrode is able to move relatively to the workpiece to be coated.

According to at least one embodiment of the present disclosure, the at least one electrode is configured between adjacent stages.

According to at least one embodiment of the present disclosure, each electrode between adjacent stages is configured with an orientation toward the stage.

According to at least one embodiment of the present disclosure, adjacent two electrodes form a V-shaped structure, an opening of the V-shaped structure faces outwardly, and the adjacent two electrodes respectively face adjacent two stages correspondingly.

According to at least one embodiment of the present disclosure, the electrode has a discharge surface, the movable support is provided with at least one conductive plate which is configured facing relatively to each electrode, wherein the conductive plate has a conductive surface, conductive surfaces of adjacent two conductive plates form an included angle, and conductive surfaces of adjacent two conductive plates and the discharge surface of the electrode which is configured facing the adjacent two conductive plates form a triangular discharge area.

According to at least one embodiment of the present disclosure, the at least one electrode is configured on the inner side of a plurality of stages to serve as at least one inner electrode.

According to at least one embodiment of the present disclosure, the at least one electrode is configured along the circumferential direction of the movable support and is configured between adjacent two stages to serve as at least one outer electrode.

According to at least one embodiment of the present disclosure, the movable support is configured on the reaction chamber body in a manner of being able to rotate around a first axis of the movable support center.

According to at least one embodiment of the present disclosure, the stage is configured on the movable support in a manner of being able to rotate around a second axis of the stage center, and the second axis is configured on the circumferential side of the first axis, wherein the movable support is configured on the reaction chamber body in a manner of being able to rotate around the first axis of the movable support center.

According to at least one embodiment of the present disclosure, the movable support device further includes a stage support frame, the stage support frame is configured on the movable support in a manner of being able to rotate around the second axis, a plurality of stages are configured on the stage support frame at intervals along the height direction, and the electrode is configured between adjacent two stage support frames.

According to at least one embodiment of the present disclosure, the coating apparatus further includes a conductive unit, the conductive unit includes a first conductive part and a second conductive part, the first conductive part is configured in the reaction chamber body, the second conductive part is configured on the movable support, the first conductive part is conductively coupled with the second conductive part, the second conductive part is conductively coupled with the electrode, and when the movable support rotates around the first axis relative to the reaction chamber body, the second conductive part is configured to rotate relative to the first conductive part and maintains conductive with the first conductive part, such that the electric energy from outside the reaction chamber can be transmitted from the first conductive part to the second conductive part, and thus to the electrode.

According to at least one embodiment of the present disclosure, the movable support includes an upper support and a lower support, the upper support is held above the lower support and forms a loading space, the second conductive part is configured on the upper support, and the first conductive part is pressed tightly and supported on the second conductive part.

According to at least one embodiment of the present disclosure, each stage includes a stage transmission part, the movable support includes a movable support engagement part, which operates as a gear to be engaged with the stage transmission part and to move relatively to the stage transmission part.

According to at least one embodiment of the present disclosure, each electrode comprises an electrode plate respectively, the movable support is provided with at least one conductive plate which is configured facing relatively to each electrode, adjacent two conductive plates form an included angle, and the adjacent two conductive plates and an electrode which is configured facing the adjacent two conductive plates form a triangular structure.

According to at least one embodiment of the present disclosure, a plurality of electrodes are configured around the first axis in centro-symmetry.

According to at least one embodiment of the present disclosure, the discharge surface of the at least one electrode is complanate or arc-shaped.

According to at least one embodiment of the present disclosure, at least one electrode is arc-shaped.

According to at least one embodiment of the present disclosure, the electrode and the movable support have opposite polarities to each other, so that the electrode can discharge toward the movable support.

According to at least one embodiment of the present disclosure, the movable support is grounded.

According to at least one embodiment of the present disclosure, the movable support is provided with a conductive surface matching the size of each electrode.

According to at least one embodiment of the present disclosure, each electrode comprises an electrode plate, and the movable support is provided with a conductive plate which is configured facing relatively to each electrode.

According to at least one embodiment of the present disclosure, the coating apparatus also includes an electrode frame, the electrode frame is configured in the reaction chamber body in a manner of being able to move relatively to the reaction chamber body, and the electrode is configured on the electrode frame.

According to at least one embodiment of the present disclosure, the electrode frame and the movable support are independent from each other.

According to at least one embodiment of the present disclosure, the electrode frame and the movable support constitute an integrated structure, and the electrode frame constitutes a part of the movable support.

According to an aspect of the present disclosure, the present disclosure also provides a movable electrode device, which is applied in a coating apparatus, the coating apparatus includes a reaction chamber body, wherein the movable electrode device includes one or more electrodes, and the electrode is a movable electrode which is configured in the reaction chamber body in a manner of being able to move relatively to the reaction chamber body.

According to at least one embodiment of the present disclosure, the coating apparatus also includes a movable support, which is configured in the reaction chamber body in a manner of being able to move relatively to the reaction chamber body, wherein the movable support is adapted to hold at least one workpiece to be coated which can move along with the movable support, and an electrode is configured on the movable support.

According to at least one embodiment of the present disclosure, the stage is configured on the movable support in a manner of being able to rotate around a second axis of the stage center, and the second axis is configured on the circumferential side of the first axis.

According to at least one embodiment of the present disclosure, a plurality of electrodes are configured around the first axis in centro-symmetry.

According to at least one embodiment of the present disclosure, the discharge surface of the at least one electrode is complanate or arc-shaped.

According to at least one embodiment of the present disclosure, at least one electrode is arc-shaped.

According to at least one embodiment of the present disclosure, the electrode and the movable support have opposite polarities to each other, so that the electrode discharges toward the movable support.

According to at least one embodiment of the present disclosure, the movable support is grounded.

According to at least one embodiment of the present disclosure, the movable support is provided with a conductive surface matching the size of each electrode.

According to at least one embodiment of the present disclosure, the movable support is provided with a conductive plate which is configured facing relatively to each electrode.

According to at least one embodiment of the present disclosure, the coating apparatus also includes a movable support, and the movable support is adapted to hold at least one workpiece to be coated which can move along with the movable support, wherein the movable electrode device also includes an electrode frame, the electrode frame is configured in the reaction chamber body in a manner of being able to move relatively to the reaction chamber body, and the electrode is configured on the electrode frame.

According to at least one embodiment of the present disclosure, the electrode frame and the movable support are independent from each other.

According to at least one embodiment of the present disclosure, the electrode frame and the movable support constitute an integrated structure, and the electrode frame constitutes a part of the movable support.

According to another aspect of the present disclosure, the present disclosure provides a movable support device, which is applied in a coating apparatus, the coating apparatus includes a reaction chamber body, wherein the movable support device includes:
at least one electrode;
a movable support, wherein the movable support is movable relative to the reaction chamber body, and the at least one electrode is configured on the movable support in a manner of being able to move along with the movable support; and
at least one stage, wherein the stage is configured on the movable support in a manner of being able to move along with the movable support.

According to at least one embodiment of the present disclosure, the movable support is configured on the reaction chamber body in a manner of being able to rotate around a first axis, wherein the at least one electrode is configured on the movable support in a manner of being able to move along with the movable support, wherein the stage is configured on the movable support in a manner of being able to rotate along with the movable support around the first axis, wherein each stage is held on the movable support in a manner of being able to rotate around a second axis.

According to at least one embodiment of the present disclosure, an electrode has a discharge surface, wherein the discharge surface is configured toward a central axis of the movable support, or the electrode has a discharge surface, wherein the discharge surface is configured toward the stage and an electrode is held on the circumferential side of the stage.

According to at least one embodiment of the present disclosure, at least one electrode is held at a circumferential position of the movable support.

According to at least one embodiment of the present disclosure, the movable support device further includes a stage support frame, wherein the stage support frame is configured on the movable support in a manner of being able to rotate around the second axis, and a plurality of stages are disposed on the stage support frame at intervals along the height direction, wherein an electrode is configured between adjacent two stage support frames.

According to at least one embodiment of the present disclosure, the movable support device further includes a stage support frame, wherein the stage support frame is configured on the movable support in a manner of being able to rotate around the second axis, and a plurality of stages are disposed on the stage support frame at intervals along the height direction, wherein an electrode is configured between adjacent two stage support frames.

According to at least one embodiment of the present disclosure, the stage is a circular stage, and the radian of the electrode is the same as that of the circular stage.

According to at least one embodiment of the present disclosure, the second axis constitutes the central axis of the stage.

According to at least one embodiment of the present disclosure, wherein at least two electrodes are configured symmetrically around the first axis.

According to at least one embodiment of the present disclosure, wherein at least two electrodes are configured symmetrically around the second axis.

According to at least one embodiment of the present disclosure, wherein the stage support frame includes an upper support part, a lower support part and a side support part, wherein the upper support part is supported on the lower support part through the side support part, the second axis passes through the upper support part, the stage and the lower support part, and the at least one electrode is configured outside the side support part.

According to at least one embodiment of the present disclosure, the electrode has a discharge surface, the movable support is provided with at least one conductive plate which is configured facing relatively to each electrode, wherein the conductive plate has a conductive surface, conductive surfaces of adjacent two conductive plates form an included angle, and conductive surfaces of adjacent two conductive plates and the discharge surface of the electrode which is configured facing the adjacent two conductive plates form a triangular discharge area.

According to at least one embodiment of the present disclosure, at least two stages support frames are configured symmetrically around the first axis, and at least two electrodes are configured on the inner side of the stage support frame.

According to at least one embodiment of the present disclosure, the movable support device further includes a conductive unit, wherein the conductive unit includes a first conductive part and a second conductive part, the first conductive part is configured in the reaction chamber body, the second conductive part is configured on the movable support, the first conductive part is conductively coupled with the second conductive part, the second conductive part is conductively coupled with the electrode, and when the movable support rotates around the first axis relative to the reaction chamber body, the second conductive part is configured to rotate relative to the first conductive part and maintains conductive with the first conductive part, such that the electric energy from outside the reaction chamber can be transmitted from the first conductive part to the second conductive part, and thus to the electrode.

According to an embodiment of the present disclosure, the movable support includes an upper support and a lower support, the upper support is held above the lower support and forms a loading space, the second conductive part is configured on the upper support, and the first conductive part is pressed tightly and supported on the second conductive part.

According to an embodiment of the present disclosure, each stage includes a stage transmission part, the movable support includes a movable support engagement part, which operates as a gear to be engaged with the stage transmission part and to move relatively to the stage transmission part.

The present disclosure also provides an electrode discharge method, including:
when at least one workpiece to be coated moves along with a movable support relative to a reaction chamber body, at least one electrode which is movable relative to the reaction chamber body discharging relative to the movable support in the reaction chamber body.

According to an embodiment of the present disclosure, the electrode discharge method further including: driving the electrode and the workpiece to be coated to move together with the movable support.

According to an embodiment of the present disclosure, the electrode discharge method further including: generating relative movement between the electrode and the workpiece to be coated.

According to at least one embodiment of the present disclosure, the electrode discharge method further including: driving at least one stage carrying the workpiece to be coated to move by the movable support.

According to at least one embodiment of the present disclosure, the electrode discharge method further including: driving the stage to rotate around a first axis of the movable support center and around a second axis of the stage center, and driving the electrode to rotate around the first axis.

### BRIEF DESCRIPTION OF THE DRAWINGS

FIG. 1 schematically illustrates a coating apparatus according to an embodiment of the present disclosure.
FIG. 2 schematically illustrates a movable support device according to an embodiment of the present disclosure.
FIG. 3 schematically illustrates the movable support device according to the above-mentioned embodiment of the present disclosure.
FIG. 4 schematically illustrates a top view of the movable support device according to the above-mentioned embodiment of the present disclosure.
FIG. 5A schematically illustrates discharge of the movable support device according to the above-mentioned embodiment of the present disclosure.
FIG. 5B schematically illustrates discharge of a movable support device according to another embodiment of the present disclosure.
FIG. 5C schematically illustrates discharge of a movable support device according to another embodiment of the present disclosure.
FIG. 5D schematically illustrates discharge of a movable support device according to another embodiment of the present disclosure.
FIG. 5E schematically illustrates discharge of a movable support device according to another embodiment of the present disclosure.
FIG. 6 schematically illustrates electrode conduction of the coating apparatus according to the above-mentioned embodiment of the present disclosure.
FIG. 7 schematically illustrates another electrode conduction mode of the coating apparatus according to the above-mentioned embodiment of the present disclosure.
FIG. 8 schematically illustrates the feeding of the coating apparatus according to the above-mentioned embodiment of the present disclosure. And
FIG. 9 schematically illustrates the application of the coating apparatus according to the above-mentioned embodiment of the present disclosure.

### DETAILED DESCRIPTION

The following description serves to disclose the disclosure to enable those skilled in the art to practice the present disclosure. The preferred embodiments in the following description are only examples. Those skilled in the art may think of other obvious variations. The basic principles of the present disclosure as defined in the following description may be applied to other embodiments, variations, modifications, equivalents, and other technical solutions without departing from the spirit and scope of the present disclosure.

Those skilled in the art will appreciate that, in the disclosure of the present disclosure, the terms "longitudinal", "transverse", "upper", "lower", "front", "rear", "left", "right", "vertical", "horizontal", "top", "bottom", "inner", "outer" and the like indicate azimuth or positional relationships based on the azimuth or positional relationships shown in the drawings. It is only intended to facilitate the description and simplify the description, and not to indicate or imply that the apparatus or element referred to must have a particular orientation, be constructed and operated in a particular orientation, so the above-mentioned terms are not to be construed to limit the present disclosure.

It will be appreciated that the term "a", "an", or "one" is to be understood as "at least one" or "one or more", i.e., in one embodiment, the number of one element may be one and in another embodiment the number of one element may be multiple, and that the term "a", "an", or "one" is not to be construed to limit the number.

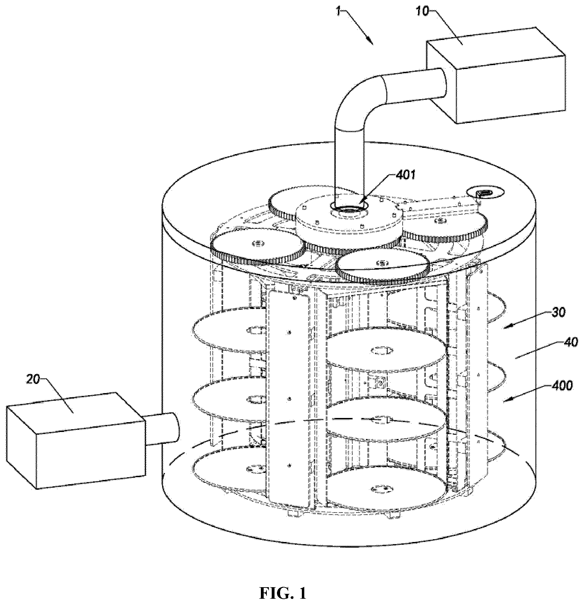

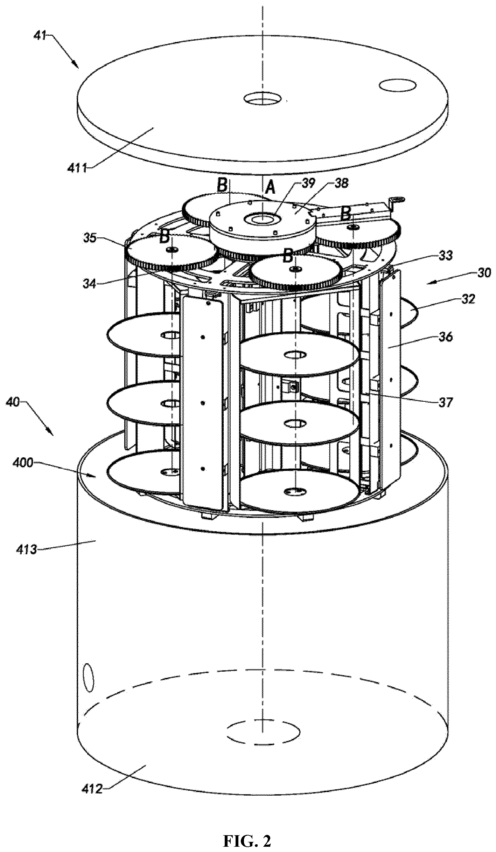

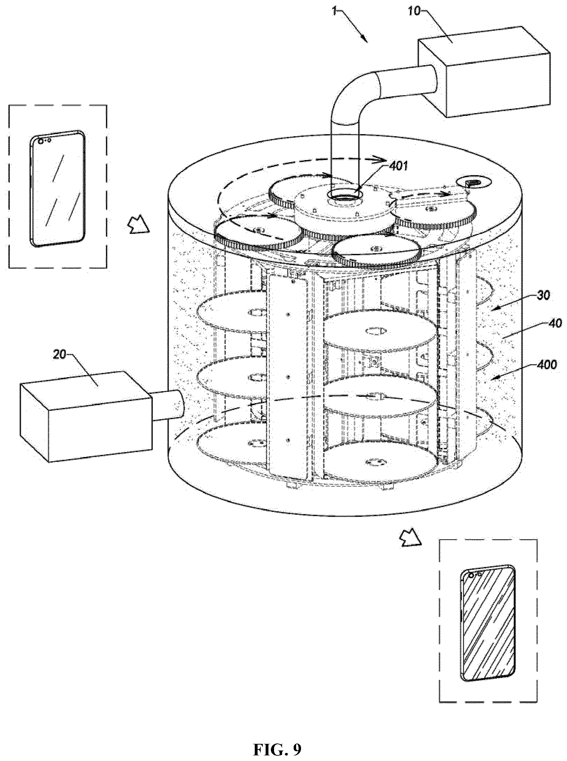

Referring to Figure 1 to 4, a movable support device 30 and a coating apparatus 1 according to an embodiment of the present disclosure is illustrated respectively. Referring to FIG. 9, a schematic diagram of an application of the coating apparatus 1 is illustrated.

The coating apparatus 1 can be used to form a coating on the surface of a workpiece to be coated, and the coating can protect the surface of the workpiece to be coated, so as to prolong the service life of the workpiece to be coated.

The coating apparatus 1 includes: a feeding device 10, a pumping device 20, a movable support device 30, a reaction chamber body 40, and a movable electrode device 50, wherein the reaction chamber body 40 includes a housing 41 and is provided with a reaction chamber 400, and the housing 41 surrounds the reaction chamber 400.

The feeding device 10 may be used for feeding, such as reactant gas which is directly from a gas source or generated by vaporizing of liquid raw materials. In some embodiments, the feeding device 10 is coupled with the housing 41 which is coupled with the reaction chamber 400.

The pumping device 20 may be used for pumping to ensure that the reaction chamber 400 is in an expected negative pressure environment. In some embodiments, the pumping device 20 is communicated with the housing 41 which is coupled with the reaction chamber 400.

The movable support device 30 may be used for placing the workpiece to be coated, and the workpiece to be coated held on the movable support device 30 can be coated in the reaction chamber body 40. In some embodiments, the movable support device 30 is configured in the reaction chamber 400 and is rotatably coupled with the housing 41.

The movable electrode device 50 can discharge and move relatively to the workpiece to be coated to facilitate the coating effect of the workpiece to be coated. In some embodiments, the movable electrode device 50 includes a plurality of electrodes 36, and at least one electrode 36 can move relatively to the reaction chamber body 40.

In some embodiments, the reaction chamber body 40 has a symmetrical structure, such as a cylinder, so as to facilitate a uniform distribution of the reactant gas in the reaction chamber 400.

In some embodiments, the movable support device 30 includes a movable support 31, wherein the movable support 31 of the movable support device 30 can move relatively to the reaction chamber 40, and the workpiece to be coated is held in the movable support device 30 so that the workpiece to be coated can move relatively to the reaction chamber body 40.

The movable support 31 can, but is not limited to, rotate relative to the reaction chamber body 40, such as rotation, reciprocating motion, swing, etc.

The electrode 36 can discharge, for example, the electrode 36 movable relatively to the reaction chamber body 40 is a cathode, and the reaction chamber body 40 may be made of conductive metal to serve as an anode to discharge in the reaction chamber 400. According to the embodiment of the present disclosure, the movable support 31 and the electrode 36 have opposite polarities to each other, so that the electrode 36 can discharge toward the movable support 31, and the movable support 31 can be further grounded.

In this embodiment, the movable support device 30 is coupled with the housing 41 in a manner of being able to rotate around a first axis A, the housing 41 includes an upper housing 411, a lower housing 412 and a side wall 413, wherein the side wall 413 extends between the upper housing 411 and the lower housing 412. The upper housing 411, the lower housing 412 and the side wall 413 encompass to form the reaction chamber body 400. The upper housing 411 and the lower housing 412 are configured facing to each other.

The feeding device 10 may be coupled with the upper housing 411, the lower housing 412 or the side wall 413 of the housing 41. The pumping device 20 may be communicated with the upper housing 411, the lower housing 412 or the side wall 413 of the housing 41. Optionally, a feeding inlet 401 and an exhausting outlet of the reaction chamber body 40 are configured symmetrically. Of course, this is only for an illustration purpose, and those skilled in the art can adjust according to practical needs.

Optionally, the first axis A is a central axis of the reaction chamber body 40, and the first axis A may also be a central axis of the movable support device 30.

The workpiece to be coated is arranged around the first axis A and can rotate around the first axis A following the rotation of the movable support device 30. In this process, on the one hand, the movable support device 30 drives the gas flow in the reaction chamber body 40, and the movable support device 30 acts as a stirrer, which is beneficial to the uniform mixing of the reactant gas in the reaction chamber body 40. On the other hand, the workpiece to be coated is driven by the movable support device 30 to move relatively to the reaction chamber body 40, which increases the chances of contact between the workpiece to be coated and the reactant gas at various positions in the reaction chamber body 40, thereby being beneficial to the uniformity of the coating.

It is worth mentioning that the workpiece to be coated can rotate around the first axis A, and rotate around the second axis B either. The second axis B is located on the circumferential side of the first axis A. When the number of stages 32 is plural, each stage 32 corresponds to one second axis B. Preferably, the first axis A is the central axis of the movable support 31, and the second axis B is the central axis of the stage 32.

It should be understood that in addition to rotating around its central axis, in other embodiments, the workpiece to be coated can also be driven to move in other ways, such as reciprocating, elliptical, spherical, planetary, etc. While the electrode 36 can move relative to the reaction chamber body 40, it also can move relative to the workpiece to be coated.

Specifically, the movable support device 30 includes the movable support 31 and at least one stage 32, wherein the at least one stage 32 is configured on the movable support 31. The stage 32 may be used for accommodating the workpiece to be coated. A single movable support 31 can be configured with a plurality of stages 32, which can be laid in a plane or piled up. That is, the movable support 31 has a predetermined height, and the plurality of stages 32 can be placed in the height direction to accommodate more workpieces to be coated.

The stage 32 can move along with the movable support 31 by rotating around the first axis A. The stage 32 can also rotate around the second axis B. In some embodiments, the stage 32 can rotate around the first axis A, and at the same time, the stage 32 can rotate as well as around the second axis B. In this way, on the one hand, it is beneficial to increase the stirring intensity of the movable support device 30 for the reactant gas in the whole reaction chamber body 40. On the other hand, it is beneficial to increase the chances of contact between each part of the workpiece to be coated on the stage 32 and the reactant gas in the reaction chamber body 40, so as to facilitate the uniformity of the coating at each position of the workpiece to be coated.

Specifically, the movable support 31 includes an upper support 311 and a lower support 312, and a plurality of upright columns 313, wherein the upper support 311 is located higher than the lower support 312, the upper support 311 is close to the upper housing 411 of the housing 41, and the lower support 312 is close to the lower housing 412 of the housing 41. The upright column 313 is respectively coupled with the upper support 311 and the lower support 312. The upper support 311 is supported by the lower support 312 through the upright column 313.

The movable support 31 is provided with at least one loading space 310, wherein the at least one loading space 310 is located in the reaction chamber 400 and coupled with the reaction chamber 400. The stage 32 is held at a predetermined height position of the loading space 310, and the stage 32 is rotatably held in the at least one loading space 310.

More specifically, the movable support device 30 further includes a stage support frame 33, wherein the stage support frame 33 is coupled with the upper support 311 and the lower support 312 of the movable support 31 respectively, and the stage support frame 33 is coupled with the upper support 311 and the lower support 312 of the movable support 31 in a manner of being able to rotate around the second axis B. The number of the stage support frame 33 may be plural, and the plurality of stage support frames 33 are configured on the movable support 31 around the first axis A.

When the movable support 31 of the movable support device 30 is driven to rotate around the first axis A, the stage support frame 33 of the movable support device 30 can be driven to rotate around the second axis B, so that the workpiece to be coated placed on the movable support device 30 can rotate around the second axis B as well as around the first axis A at a same time.

Furthermore, the plurality of stages 32 may be configured on a single stage support frame 33 and disposed upon the stage support frame 33 in sequence along the height direction. Optionally, the second axis B passes through the center of each stage 32 of a single stage support frame 33. That is, the stage 32 can rotate around the first axis A or the second axis B in the reaction chamber body 400.

Optionally, the stage 32 may be shaped in circular, triangular, rectangular, etc. In some embodiments, the stage 32 may also be of irregular shape. It should be understood by those skilled in the art that the present disclosure is presented by the way of example only, and not limitation.

In this embodiment, the stage support frame 33 includes an upper support part 331, a lower support part 332 and a side support part 333, wherein the upper support part 331 and the lower support part 332 are configured facing to each other, and the upper support part 331 and the lower support part 332 are connected by the side support part 333. The stage 32 is fixed to the side support 333, which can be provided with a plurality of stages 32.

The entire stage support frame 33 can be driven to rotate around the second axis B which passes through the upper support 311 and the lower support 312 of the movable support 31, and the upper support part 331 and the lower support part 332 of the stage support frame 33.

The stage support frame 33 is designed so that the stage 32 can be sufficiently exposed to the reaction chamber 400 to facilitate the contact between the workpiece to be coated placed on the stage 32 and the reactant gas in the reaction chamber 400. Optionally, the stage support frame 33 is a rectangular structure. Optionally, the stage support frame 33 is a hollow structure.

In this embodiment, the number of the stage support frame 33 is plural, such as four, which are respectively configured around the first axis A. Preferably, the stage support frame 33 is evenly configured around the first axis A.

It should be understood that the number of the stage support frames 33 can be one, two or more, and those skilled in the art could adjust the number of the stage support frames 33 reasonably according to actual needs.

Furthermore, the rotation of the movable support 31 of the movable support device 30 around the first axis A and the rotation of the stage support frame 33 around the second axis B can be linked.

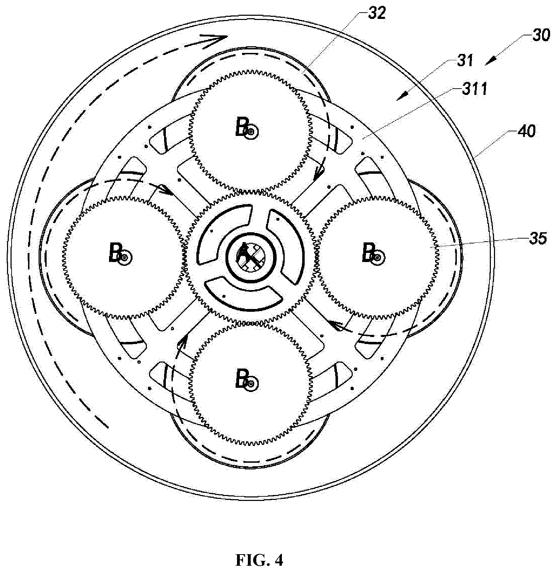

Referring to FIG. 4, specifically, the movable support device 30 also includes a movable support engagement part 34 and at least one stage transmission part 35. In some embodiments, the at least one stage transmission part 35 is implemented as a gear structure, and the movable support engagement part 34 is an intermediate gear that engages with a corresponding stage transmission part 35, wherein the movable support engagement part 34 is fixedly configured on the movable support 31, and each stage transmission part 35 can rotate relative to the movable support engagement part 34. The stage transmission part 35 is configured around the movable support engagement part 34.

In other words, the rotation of the movable support engagement part 34 is restricted to the stage transmission part 35, and the rotation of the stage transmission part 35 is restricted to the movable support engagement part 34. The movable support engagement part 34 and the stage transmission part 35 interact with each other. The movable support engagement part 34 is fixed to the movable support 31, and the movable support engagement part 34 and the movable support 31 can rotate around the first axis A together. The stage transmission part 35 is fixed to the stage support frame 33, and the stage transmission part 35 and the stage support frame 33 can rotate around the second axis B. Therefore, the relative movement between the movable support 31 and the stage support frame 33 can be controlled by controlling the movable support engagement part 34 and the stage transmission part 35. In this way, the workpiece to be coated can rotate around the first axis A and the second axis B, the specific structure of the movable support device 30 can be further referred to Chinese patent ZL201611076982.8, the contents of which are incorporated herein by reference.

Optionally, the movable support engagement part 34 and the stage transmission part 35 are respectively implemented as a gear, and the movable support engagement part 34 is engaged with the stage transmission part 35. The relative movement between the movable support 31 and the stage support frame 33 can be controlled by controlling the relevant parameters of the movable support engagement part 34 and the stage transmission part 35, such as the movement speed ratio of the movable support 31 and the stage support frame 33.

It is worth mentioning that, by means of the movable support engagement part 34 and the stage transmission part 35, the simultaneous rotation of the movable support 31 and the stage support frame 33 can be realized by driving the movable support 31 or one stage support frame 33.

According to the embodiment, the movable support engagement part 34 is implemented to be fixed relative to the movable support 31, and the movement of each stage transmission part 35 is controlled by controlling the transmission between the movable support engagement part 34 and each stage transmission part 35, for example, maintaining the balance of the movement of each stage transmission part 35.

In this embodiment, the movable support engagement part 34 is held above the upper support 311 of the movable support 31. The movable support engagement part 34 may be supported on the upper support 311. The stage transmission part 35 is held above the upper support 311 of the movable support 31. A certain interval is maintained between the stage transmission part 35 and the upper support 311 to facilitate the rotation of the stage transmission part 35 relative to the upper support 311.

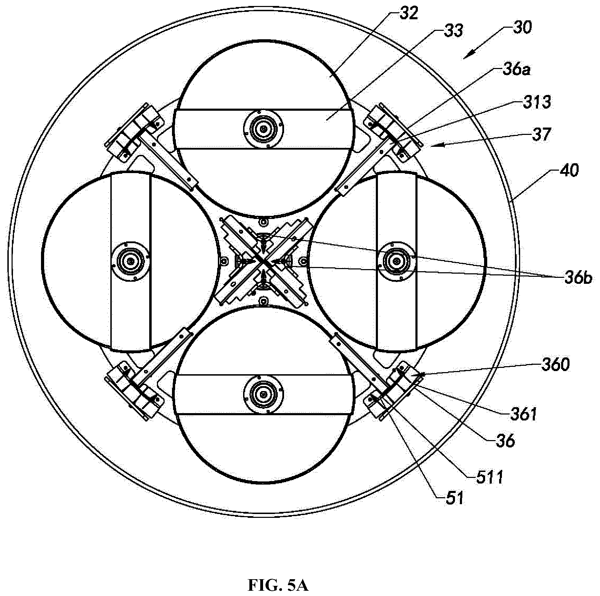

Furthermore, referring to FIG. 4 and FIG. 5A, the movable support device 30 includes a plurality of electrodes 36, wherein the plurality of electrodes 36 are configured on the movable support 31. The plurality of electrodes 36 can discharge relative to the movable support 31 in the reaction chamber body 40 after being electrified, so that the reactant gas reacts in an ionized environment and then deposits on the surface of the workpiece to be coated to form a coating.

In other words, in this embodiment, the electrode 36 can rotate together with the movable support 31, so that the electrode 36 can move relatively to the reaction chamber body 40, and thus facilitating the uniformity of the coating of the workpiece to be coated.

Specifically, during the operation of the coating apparatus 1, the housing 41 of the reaction chamber body 40 remains fixed, the movable support 31 of the movable support device 30 rotates around the first axis A, the electrode 36 configured on the movable support 31 and the stage 32 rotate together around the first axis A, and the stage 32 rotates around the second axis B at the same time. That is, there is a relative movement between the electrode 36 and the stage 32. The electrode 36 discharges to generate a plasma environment. Compared with the workpiece to be coated placed on the stage 32, the movable electrode 36 is beneficial to provide a uniform coating environment for the workpiece to be coated.

It is notable that, the electrode 36 may be configured evenly around the stage 32 to facilitate providing a uniform plasma environment. Especially for a workpiece to be coated with two surfaces to be coated, the workpiece to be coated can be placed longitudinally on the stage 32, one electrode 36 configured on the circumferential side of the stage 32 can face the front of the workpiece to be coated, and the other electrode 36 configured on the circumferential side of the stage 32 can face the back of the workpiece to be coated, which facilitate the uniform coating on both sides of the workpiece to be coated.

In some embodiments, at least one upright column 313 is configured at the circumferential position of the upper support 311 and the lower support 312, and the electrode 36 is configured on the upright column 313 and facing the middle position of the movable support 31.

In some embodiments, the electrode 36 may be an electrode plate and is placed longitudinally between the upper support 311 and the lower support 312. In some embodiment, the electrode 36 is held by the upright column 313 between the upper support 311 and the lower support 312 of the movable support 31.

In some embodiments, one electrode 36 is configured between two stage support frames 33. When there are four the stage support frames 33, there are four electrodes 36 located at the circumferential positions of the movable support 31.

Furthermore, the movable support device 30 may include an electrode frame 37, which is configured on the housing 41 of the reaction chamber body 40 and can move relatively to the reaction chamber body 40. The electrode 36 is configured on the electrode frame 37 in a manner of being able to move together with the electrode frame 37. It is notable that the electrode 36 movable together with the electrode frame 37 can move relative to the reaction chamber body 40, and relative to the workpiece to be coated too.

It is notable that the electrode 36 may be a negative electrode or a positive electrode, and the electrode 36 can cooperate with another conductive plate 51 to discharge, so as to provide an electric field. The conductive plate 51 may be configured on the electrode frame 37 or the housing 41 of the reaction chamber body 40.

The conductive plate 51 has a conductive surface 511, wherein the conductive surface 511 faces a discharge surface 361 of the electrode 36. It is notable that, the conductive surface 511 and the discharge surface 361 may be complanate or arc-shaped. In this embodiment, the conductive surface 511 and the discharge surface 361 are respectively implemented in arc-shaped, and there is configured an interval between the conductive surface 511 and the discharge surface 361 to form a discharge area 360. Optionally, an intervals width between the conductive surface 511 and the discharge surface 361 are constant.

In this embodiment of the present disclosure, the conductive plate 51 is integrally configured on a grounded movable support 31, or the movable support 31 may form a conductive surface 511 without an individual plate, the conductive surface 511 is corresponding to the size of the electrode 36 at the position of the corresponding electrode 36.

Alternatively, at least a part of the housing 41 of the reaction chamber body 40 is electrically conductive, so that discharging can occurs between the electrode 36 and the housing 41 of the reaction chamber body 40.

In this embodiment, the electrode frame 37 is configured on the movable support 31, and the electrode frame 37 includes at least one upright column 313. In other words, the electrode frame 37 constitutes a part of the movable support 31, so that the electrodes 36 are directly configured on the movable support 31. As another variant, the electrode frame 37 and the movable support 31 may be independent from each other, that is, in at least one embodiment of the present disclosure, the electrode frame 37 may be directly configured on the housing 41 of the reaction chamber body 40, and the electrode frame 37 may be configured on the housing 41 but is not limited to in a rotating manner.

In this embodiment of the present disclosure, the electrode 36 and the conductive plate 51 may be configured on the movable support 31 and insulated from each other. The conductive plate 51 is configured on the inner side of the electrode 36, when the electrode 36 and the conductive plate 51 are conductive respectively. The electrode 36 configured on the outer side of the conductive plate 51 can discharge toward the conductive plate 51. Of course, those skilled in the art should understand that the discharge mode here is only for an illustration purpose.

It is notable that the electrode 36 is configured between adjacent stage support frames 33. That is, the electrode 36 is configured between the adjacent stages 32, and is configured at the circumferential position of the movable support 31. When the electrode 36 is not configured on the movable support 31, There is still a space between the adjacent stage support frames 33. Therefore, the electrode 36 configured on the movable support 31 does not occupy effective spaces of the movable support 31, which means configuring the electrode 36 does not increase the size of the movable support 31.

It is notable that the electrode 36 is located at the circumferential position of the movable support 31. The electrode 36 may be configured at the circumferential position of the movable support 31, between the upper support 311 and the lower support 312. The electrode frame 37 may be configured at the circumferential position of the movable support 31, between the upper support 311 and the lower support 312. The electrode 36 is configured on the electrode frame 37, and the electrode 36 is configured on the electrode frame 37 at the circumferential position of the movable support 31.

According to at least one embodiment of the present disclosure, each of the stage support frames 33 may correspond to an electrode 36, and the electrode 36 may be configured outside the stage support frame 33.

According to at least one embodiment of the present disclosure, the electrode 36 may be configured between adjacent stage support frames 33, and the interval width between the electrode 36 and the middle position of the movable support 31 is less than the radius of the movable support 31. Of course, those skilled in the art could understand that the cross section of the movable support 31 may be a circle, triangle or other shape.

According to at least one embodiment of the present disclosure, the electrode 36 may be configured on the stage support frame 33. That is, the electrode 36 can rotate around the first axis A as well as rotating around the second axis B.

Furthermore, at least a part of the electrode 36 is configured at the middle position of the movable support 31. Specifically, at least a part of the electrode 36 is configured among the plurality of stage support frames 33 and is configured around the first axis A. That is, the electrode 36 may be configured on the inner side of the stage support frame 33 so as to be close to the first axis A.

One upright column 313 or a plurality of upright columns 313 may be configured at the middle position between the upper support 311 and the lower support 312, and the electrode 36 may be configured on the upright column 313 and between the upper support 311 and the lower support 312.

The electrodes 36 located at the middle position of the movable support 31 may be plural, such as four. The electrodes 36 located at the middle position of the movable support 31 may be configured facing to each other and can discharge at the middle position of the movable support 31 after being electrified. Other electrodes 36 may be configured outside the middle position of the movable support 31, such as the circumferential position of the movable support 31.

Preferably, the electrode 36 is configured symmetrically around the first axis A. It is notable that, in this embodiment, at least a part of the electrodes 36 are located on the inner side, and at least a part of the electrodes 36 are located on the outer side. Electrodes 36 located on the outer side faces the middle position of the movable support 31 and can discharge toward the middle position of the movable support 31, so that a plasma environment around the entire movable support 31 is formed. An electrode 36 located on the inner side is called an inner electrode 36b, and an electrode 36 located on the outer side is called an outer electrode 36a, wherein an inner electrode 36b is closer to the first axis A relative to the outer electrode 36a.

The inner electrode 36b can discharge toward the upright column 313 in the middle position, and at least a part of the upright column 313 may be made of conductive material. The outer electrode 36a can discharge toward the conductive plate 51 located on the inner side, and the conductive plate 51 is configured on the electrode frame 37and is insulated from the electrode frame 37. That is, the upright column 313 can provide a conductive surface 511 which can be used as at least a part of the conductive plate 51 to cooperate with the electrode 36 for discharge.

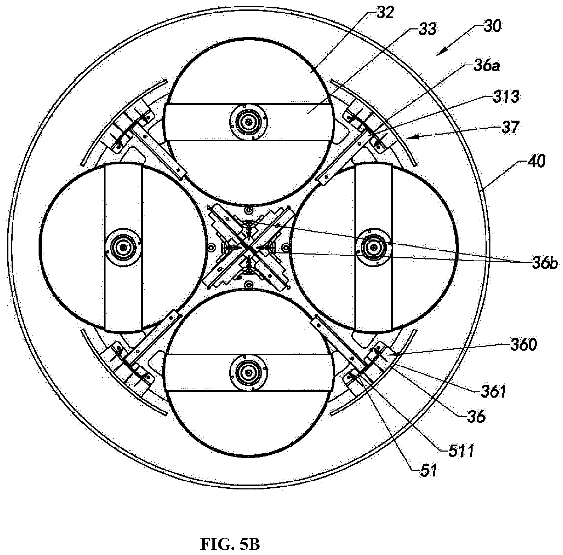

The electrode 36 can be complanate, hollow or arc-shaped, for example, as shown in Fig. 5B.

For example, some electrodes 36 are configured at the circumferential position of the movable support 31, and the radian of the electrode 36 may respond to the circumference of the movable support 31.

In other words, the electrode 36 has a discharge surface 361, wherein the discharge surface 361 may face the middle position or other positions of the movable support 31.

The discharge surface 361 is complanate or arc-shaped, so as to facilitate providing a uniform electrical environment.

The entire electrode 36 may also be arc-shaped, such as a circular arc electrode, or an electrode with an undulating discharge surface.

It is notable that, for the workpiece to be coated, when the workpiece to be coated rotates around the first axis A and the second axis B, sometimes it may rotate to a position between an electrode 36 located on the outside and an electrode 36 located on the inside, that is, the inner area of two opposite electrodes 36, which facilitates the rapid deposition of plasma on the surface of the workpiece to be coated under the action of electric field. Sometimes, the workpiece to be coated may rotate to a position outside the inner area between an electrode 36 located on the outside and an electrode 36 located on the inside, which may avoid the loss of the surface of the workpiece to be coated due to being between two opposite electrodes 36 for a long time.

It should be understood that the reaction chamber body 40 of the present disclosure may also be provided with other electrodes, which may be fixedly configured in the reaction chamber body 40. These electrodes discharge at fixed positions, and cooperate with the movable electrodes 36 of the present disclosure to provide a suitable discharge environment in the reaction chamber body 40.

It is worth mentioning that, the electrode 36 of the movable support device 30 is movable, the movable electrodes 36 can not only result in uniform coating, but also result in a part of the raw gas for the coating being fully ionized when passing through the discharge area, and a part of the raw gas for the coating being not fully ionized which does not pass through the discharge area between the electrode 36 and the conductive plate 51. In this way, a rich coating structure with stable coating quality can be obtained through raw materials without ionized state by adjusting coating parameters.

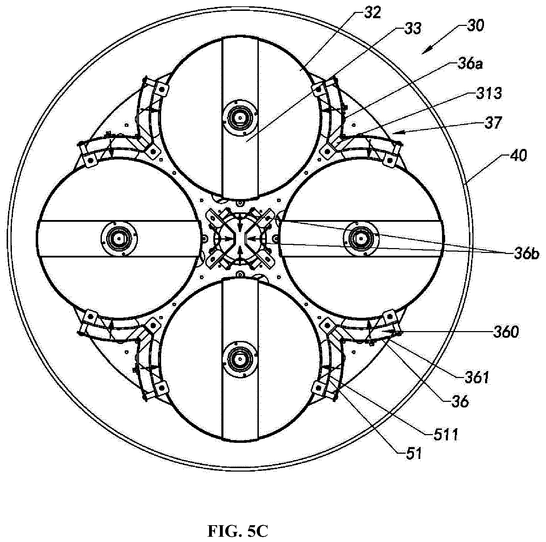

The electrodes 36 can also be configured in other ways. For example, referring to FIG. 5C, according to the above preferred embodiment of the present disclosure, another arrangement of the electrodes 36 of the movable support device 30 is illustrated.

In this embodiment, at least a part of the electrodes 36 are configured toward the stage 32. That is, discharge surface of the part of the electrodes 36 face the stage 32.

The movable support 31 is provided with the loading space 310, and one of the stage support frames 33 separates the loading space 310.

At least one electrode 36 is configured around the stage 32 corresponding to one stage support frame 33, and the at least one electrode 36 is placed longitudinally between the upper support 311 and the lower support 312 of the movable support 31.

The at least one electrode 36 may discharge toward the stage 32 within the loading space 310. The difference from the previous embodiment is that in the previous embodiment, the electrodes 36 located outside discharge toward the middle position of the movable support 31, and the entire movable support 31 is encapsulated in a large plasma environment.

In this embodiment, the electrode 36 discharges at the corresponding stage 32 which is adjacent to the electrode 36, and different electrodes 36 are adjacent to one or more different stages 32, which is beneficial to the control of the coating uniformity of each loading space 310.

Furthermore, each stage support frame 33 corresponds to at least two electrodes 36. Preferably, the electrodes 36 are configured symmetrically around the second axis B.

Specifically, the electrode 36 extends inwardly from the circumferential position of the movable support 31 to the inner position of the movable support 31, and the electrodes 36 surround the stage 32. There is an interval between the electrode 36 and the stage support frame 33 and between the electrode 36 and the stage 32 respectively. Thus, the electrode 36 does not impede the rotation of the stage support frame 33 and the rotation of the stage 32.

When the stage support frame 33 and the stage 32 rotate around the second axis B, the stage support frame 33 and the stage 32 can move relatively to the electrode 36, which facilitates the uniform diffusion of the plasma generated after the discharging of the electrode 36 in the stage 32.

It is notable that, for the workpiece to be coated, when the workpiece to be coated rotates around the first axis A and the second axis B, sometimes it may rotate to a position between electrodes 36 on both sides of the stage 32, that is, the inner area of two opposite electrodes 36, which facilitates the rapid deposition of plasma on the surface of the workpiece to be coated under the action of electric field. Sometimes, the workpiece to be coated may rotate to a position outside the inner area between electrodes 36 located on both sides of the stage 32, which may avoid the loss of the surface of the workpiece to be coated due to being exposed between the two opposite electrodes 36 for a long time.

Furthermore, the electrode is configured on the upright column 313 of the electrode frame 37, the upright column 313 is located on the inner side of the electrode 36, and the upright column 313 is hollow-shaped, which facilitates the electrode 36 discharge.

It is worth mentioning that, in this embodiment, the electrodes 36 located on the outer side have a certain radian, which facilitates the discharge uniformity of the electrodes 36. In some embodiments, the electrode frames 37 may be configured to have the same radian as the electrodes 36.

Specifically, the motion trail of the workpiece to be coated placed on the stage 32 is circular when it rotates around the second axis B, and the electrodes 36 are set in circular arc so that the discharge of the electrodes 36 can respond to the motion trail of the workpiece to be coated, which facilitates creating a uniform coating environment for the workpiece to be coated.

Preferably, the radian of the circular trail of the workpiece to be coated is the same as that of the electrodes 36, and has the same circle center.

Furthermore, in this embodiment, the number of the stage support frames 33 is plural, such as four, and the electrodes 36 are configured between the adjacent stage support frames 33. The electrodes 36 of the adjacent stages support frames 33 are configured on a same part of the electrode frame 37. Adjacent electrodes 36 may be coupled with each other and form a V-shaped structure and an opening of the V-shaped structure faces outwardly.

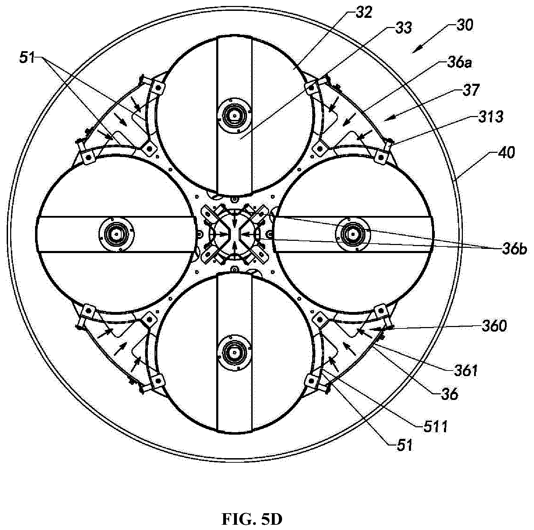

Referring to Fig. 5D, another embodiment of the movable support device 30 according to the present disclosure is illustrated. In this embodiment, the conductive plates 51 configured facing to the electrode 36 are configured to face the stage 32. An area between the discharge surface 361 of the electrode 36 and the conductive surfaces 511 of the conductive plates 51 forms a discharge area 360, and the discharge area 360 constitutes a triangular chamber.

Adjacent conductive plates 51 form a V-shaped structure. One electrode 36 as an electrode plate faces the V-shaped conductive plates 51 to form a triangular structure.

Specifically, the conductive plate 51 may be configured on the movable support 31, and the conductive plate 51 is configured to be grounded. Adjacent conductive plates 51 are located between two stages 32, one conductive plate 51 of the adjacent conductive plates 51 faces one stage 32 of the two stages 32, and other conductive plate 51 of the adjacent conductive plates 51 faces the other stage 32 of the two stages 32. An included angle is formed between adjacent two conductive plates 51, and the included angle faces the electrode 36.

One end of the electrode 36 is close to one stage 32, and the other end of the electrode 36 is close to the other stage 32. From one end of the electrode 36 to the other end, the interval between the electrode 36 and the conductive plate 51 changes from gradually increasing to gradually decreasing. That is, the size of the discharge area 360 corresponding to one end of the electrode 36 to the other end changes from gradually increasing to gradually decreasing.

It is notable that, the conductive plate 51 may be configured in a complanate structure or an arc structure. In this embodiment, the conductive plate 51 is configured to be bent toward the stage 32.

In other words, the electrode 36 and the conductive plates 51 are configured facing to each other. Since the electrode 36 and the conductive plates 51 form a triangular structure, the grounding distance between the electrode 36 and the grounded conductive plates 51 is changing. When the electrode 36 discharges, the discharge can autonomously select the optimal channel of the discharge area 360 between the electrode 36 and the conductive plates 51, and the entire discharge process can be more stable and reliable.

It is worth mentioning that, the plasma generated during the discharge process can be localized in the discharge area 360 formed by the electrode 36 and the conductive plates 51, so as to improve external uniformity.

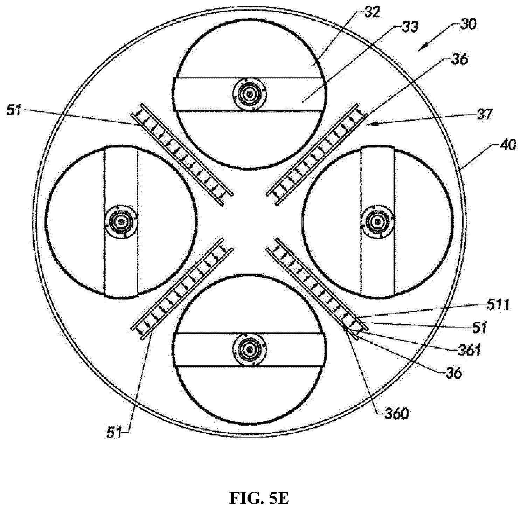

Furthermore, referring to Fig. 5E, the electrode 36 may be configured along the radial direction of the movable support 31. Specifically, the electrode 36 extends from a position close to the first axis A to a circumferential position close to the movable support 31.

The electrodes 36 are configured between the adjacent stages 32. Optionally, one electrode 36 is configured between every adjacent two stages 32. When there are four stages 32, there are four electrodes 36 too. Optionally, the discharge direction of each electrode 36 is the same, for example, in a clockwise direction or a counterclockwise direction from a top view.

Preferably, a plurality of the electrodes 36 are evenly configured around the first axis A, so as to facilitate providing a uniform electric field for the workpieces to be coated on each stage 32.

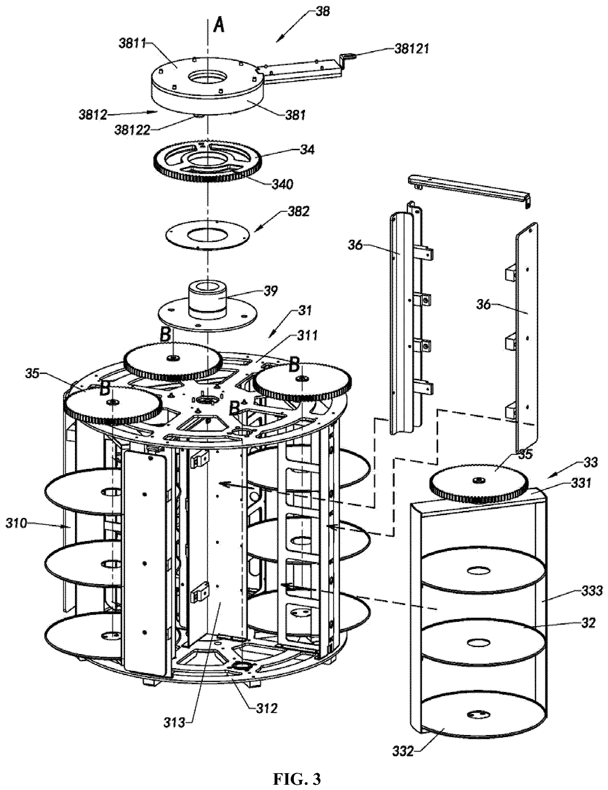

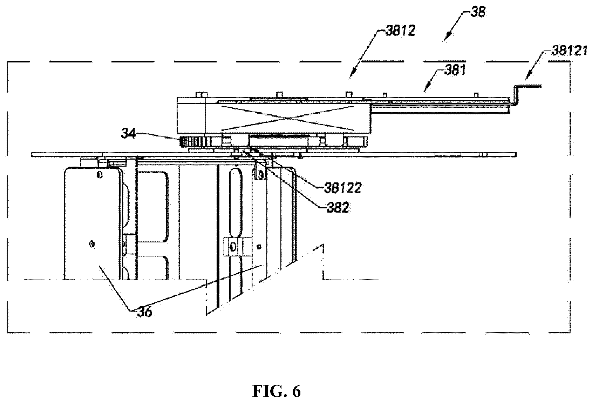

Furthermore, referring to FIG. 3 and FIG. 6, a conductive unit 38 of the movable support device 30 according to the above-mentioned preferred embodiment of the present disclosure is illustrated.

The conductive unit 38 includes a first conductive part 381 and a second conductive part 382, wherein the first conductive part 381 is configured on the housing 41 of the reaction chamber body 40, the second conductive part 382 is configured on the movable support 31, and the second conductive part 382 can move following the movable support 31.

The first conductive part 381 and the second conductive part 382 can move relatively to each other, so that when the movable support 31 of the movable support device 30 rotates relatively to the reaction chamber body 40, the external power supply can be supplied to the electrode 36 rotating along with the movable support 31 in the reaction chamber body 40.

In this embodiment, the first conductive part 381 is configured on the upper housing 411 of the housing 41 and supported on the upper support 311 of the movable support 31. That is, the first conductive part 381 of the conductive unit 38 is located between the upper housing 411 and the movable support 31. The first conductive part 381 is used to transmit the electric power outside the reaction chamber body 40 to the movable support 31 located in the reaction chamber body 40. The second conductive part 382 is configured on the movable support 31 and is used to transmit the electric power from the second conductive part 382 to the electrode 36 configured on the movable support 31.

Specifically, the first conductive part 381 includes a conductive component 3812, and the conductive component 3812 is provided with an insulating component 3811, wherein an insulating space is formed by the insulating component 3811, and the conductive component 3812 is located in the insulating space formed by the insulating component 3811.

The conductive component 3812 is provided with a first conductive end 38121 and a second conductive end 38122, wherein the first conductive end 38121 may be used for connecting an external power supply, and the first conductive end is exposed outside the insulating space. The second conductive end 38122 is used to conduct with the second conductive component 382, and the second conductive end 38122 is exposed outside the insulating space.

The second conductive end 38122 of the conductive component 3812 of the first conductive part 381 is conductively coupled with the second conductive part 382 to transmit external power to the electrode 36.

Specifically, during the movement of the second conductive part 382 relative to the second conductive end 38122 of the first conductive part 381, the second conductive end 38122 of the first conductive part 381 is always conductively coupled with the second conductive part 382 to maintain the stability of power supply to the electrode 36. The upper housing 411 of the housing 41 of the reaction chamber body 40 may be perforated so that the second conductive end 38122 of the first conductive part 381 is exposed. Thus, the first conductive part 381 can conduct with the outside electrically.

The first conductive part 381 may also extend to be close to the side wall 413 of the housing 41. The side wall 413 of the housing 41 may be perforated so that the second conductive end 38122 can be coupled with the outside through the side wall 413 of the housing 41.

In this embodiment, the first conductive part 381 extends in a direction away from the central axis of the movable support 31 so that the second conductive end 3812 of the first conductive part 381 is located at a faraway position.

In some embodiments, at least a part of the second conductive part 382 is located on the upper support 311 of the movable support 31 and is at least partially exposed on the top side of the upper support 311 to be coupled with the first conductive part 381. One end of the second conductive part 382 is coupled with the first conductive part 381, and the other end of the second conductive part 382 is coupled with each electrode 36 to transmit external electric energy to the electrode through the conductive unit 38.

It is notable that, in this embodiment, the conductive unit 38 is configured at the position of the central axis of the movable support 31, and the movable support engagement part 34 is also located at this position.

The movable support engagement part 34 is implemented as a gear structure, and the movable support engagement part 34 is provided with a plurality of channels 340. At least a part of the first conductive part 381 passes through the plurality of channels 340 of the movable support engagement part 34 from top to bottom, so that the at least a part of the first conductive part 381 is conductively attached to the conductive pad 3821 of the second conductive part 382 located below the movable support engagement part 34.

Furthermore, in this embodiment, the plurality of channels 340 of the movable support engagement part 34 are independent from each other and are not coupled with each other, so that the rotation of the movable support engagement part 34 is restricted by the conductive transmission part 38126 of the first conductive part 381.

When the movable support 31 rotates relative to the reaction chamber body 40, the rotation of the movable support engagement part 34 around its center may also be restricted. The stage transmission part 35 located around the movable support engagement part 34 can still rotate around the movable support engagement part 34, and can rotate around the first axis A and the second axis B at the same time.

The rotation of the stage transmission part 35 may be restricted by the movable support engagement part 34, a plurality of stage transmission parts 35 can be kept uniformly rotating by the movable support engagement part 34, which is beneficial to the uniformity of coating.

It is notable that the conductive unit 38 is detachably coupled with the housing 41 of the reaction chamber body 40 to facilitate replacement and maintenance of the conductive unit 38.

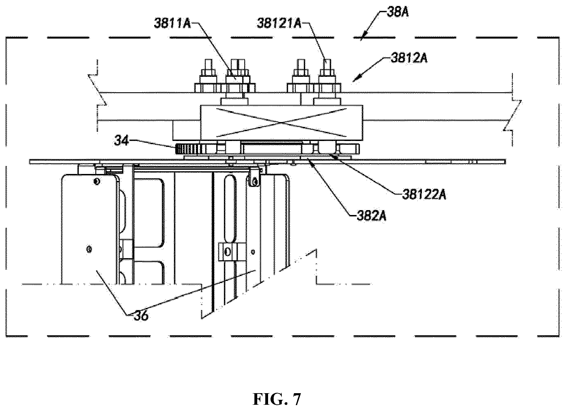

Referring to FIG. 7 and FIG. 3, another embodiment of the conductive unit 38A according to the above-mentioned preferred embodiment of the present disclosure is illustrated.

In this embodiment, the conductive unit 38A includes a first conductive part 381A and a second conductive part 382A, wherein the first conductive part 381A is configured on the housing 41 of the reaction chamber body 40, and the second conductive part 382A is configured on the movable support 31.

The first conductive part 381A is conductively coupled with the second conductive part 382A, and when the second conductive part 382A rotates along with the movable support 31, there is a relative movement between the first conductive part 381A and the second conductive part 382A. However, the first conductive part 381A is still conductive with the second conductive part 382A so that the electrode 36 in the reaction chamber body 40 can be continuously electrified.

Specifically, the first conductive part 381A includes a conductive component 3812A, and the conductive component 3812A is provided with an insulating component 3811A, wherein an insulating space is formed by the insulating component 3811A, and the conductive component 3812A is located in the insulating space formed by the insulating component 3811A.

The conductive component 3812A is provided with a first conductive end 38121A and a second conductive end 38122A, wherein the first conductive end 38121A is used for connecting an external power supply, and the first conductive end 38121A is exposed outside the insulating space. The second conductive end 38122A is used to conduct the second conductive component 382A, and the second conductive end 38122A is exposed outside the insulating space.

The second conductive end 38122A of the first conductive part 381A is conductively coupled with the second conductive part 382A to transmit external power to the electrode 36.

The difference between this embodiment and the above-mentioned embodiment lies in that, in this embodiment, the first conductive end 38121A of the first conductive part 381A is located above the second conductive end 38122A.

Furthermore, the movable support engagement part 34 is provided with at least one channel 340, at least a part of the first conductive part 381A passes through the at least one channel 340 of the movable support engagement part 34 to be conductive with the second conductive part 382A.

The movable support engagement part 34 may be made of insulating material. Optionally, the second conductive part 382A is located below the movable support engagement part 34. At least a part of the second conductive part 382A may be facing the at least one channel 340 of the movable support engagement part 34 to reduce the contact between the second conductive part 382A and the movable support engagement part 34, thereby reducing the friction between the movable support engagement part 34 and the second conductive part 382A.

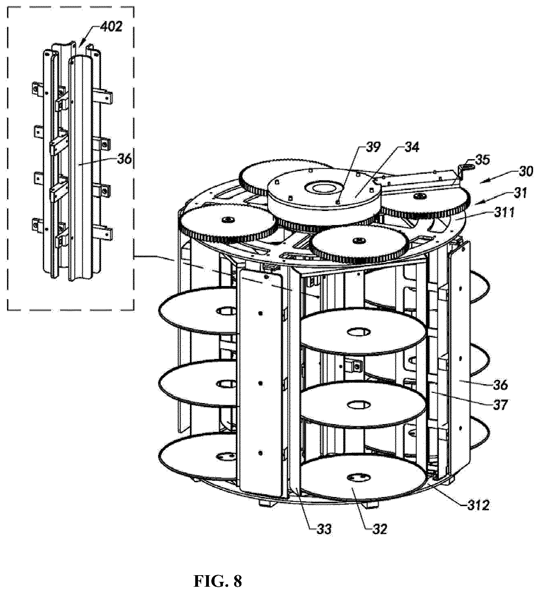

Furthermore, referring to Fig. 8, the movable support device 30 may include at least one connecting shaft 39, wherein the connecting shaft 39 can be coupled with the movable support 31, and the connecting shaft 39 can be driven to drive the movable support 31 rotate.

In this embodiment, there are two connecting shafts 39, one connecting shaft 39 is located in the upper support 311 of the movable support 31, and the other connecting shaft 39 is located in the lower support 312 of the movable support 31. The two connecting shafts 39 are located on the central axis of the movable support 31.

The reaction chamber body 40 of the coating apparatus 1 has a feeding inlet 401, wherein the feeding inlet 401 can be configured at middle position of the upper housing 411 of the housing 41 of the reaction chamber body 40 or a preset position of the upper housing 411, for example, is configured symmetrically around the first axis A.

The feeding inlet 401 at the middle position connects with a feeding channel 402 in the movable support device 30, wherein the feeding channel 402 is located at a middle position of the movable support device 30, for example, among a plurality of electrodes 36. The plurality of electrodes 36 can be partially hollowed out for the reactant gas passing through. The connecting shaft 39 may pass through the conductive unit 38.

According to the above-mentioned embodiments of the present disclosure, the present disclosure provides an electrode discharge method, which includes the following steps:
When the stage 32 rotates about the first axis A and the second axis B, the electrode 36 configured on the movable support 31 discharges relative to the movable support 31 when the movable support 31 rotates about the first axis A.

It should be understood that, during the coating process, the electrode 36 discharges toward the workpiece to be coated which is rotating around the first axis A and the second axis B. At this moment, the relative movement between the workpiece to be coated and the electrode 36 includes only the rotation of the workpiece to be coated around the second axis B. Therefore, the electrode 36 can generate a uniform ionization environment for the workpieces to be coated on the stage 32, so as to improve the coating uniformity of the workpieces to be coated on the stage 32.

According to at least one embodiment of the present disclosure, the electrode 36 configured at the circumferential position of the movable support 31 discharges toward the middle position of the movable support 31, and the workpiece to be coated is placed between the upper support 311 and the lower support 312 of the movable support 31.

According to at least one embodiment of the present disclosure, the electrode 36 configured at the circumferential position of the movable support 31 discharges toward the workpiece to be coated.

According to at least one embodiment of the present disclosure, A plurality of electrodes 36 evenly configured at the circumferential position of the movable support 31 discharges toward the workpiece to be coated.

According to another aspect of the present disclosure, the present disclosure provides an electrode power supply method, which includes the following steps:
External electrical energy can be transmitted from a first conductive part 381 to a second conductive part 382 which rotates relative to the first conductive part 381 and is coupled with an electrode 36, so that electrical energy is transmitted to the electrode 36.

According to at least one embodiment of the present disclosure, the second conductive part 382 rotates together with the electrode 36 around a first axis A.

According to at least one embodiment of the present disclosure, at least one electrode 36 is located at the middle position of a movable support 31, and at least one electrode 36 is located at the circumferential position of the movable support 31.

Those skilled in the art will appreciate that, the embodiments of the present disclosure shown in the foregoing description and the accompanying drawings are by way of example only and are not intended to limit the present disclosure. The advantages of the present disclosure have been completely and effectively realized. The functionality and structural principles of the present disclosure have been shown and illustrated in the embodiments, and embodiments of the disclosure may be varied or modified without departing from the principles described herein.

## Claims

1. A coating apparatus, comprising:
a reaction chamber body, wherein the reaction chamber body is provided with a reaction chamber;
a pumping device, wherein the pumping device is communicated with the reaction chamber body;
a feeding device, wherein the reaction chamber body has a feeding inlet, the feeding inlet is communicated with the reaction chamber, the feeding device is communicated with the feeding inlet; and
a movable support device, configured in the reaction chamber, wherein the movable support device comprises at least one electrode and a movable support, the movable support is movable relative to the reaction chamber body, the at least one electrode is configured on the movable support in a manner of being able to move along with the movable support, and the movable support is adapted to hold at least one workpiece to be coated which can move along with the movable support.

2. The coating apparatus of claim 1, wherein the at least one electrode is configured in a circumferential direction of the movable support.

3. The coating apparatus of claim 1, wherein the at least one electrode has a discharge surface, wherein the discharge surface is configured with an orientation toward a central axis of the movable support.

4. The coating apparatus of claim 1, wherein the at least one electrode has a discharge surface, wherein the discharge surface is configured with an orientation toward a workpiece to be coated.

5. The coating apparatus of claim 1, wherein the at least one electrode is configured in a radial direction of the movable support.

6. The coating apparatus of claim 1, wherein the coating apparatus further comprises at least one stage configured on the movable support, wherein the at least one stage is adapted for holding the workpiece to be coated and the at least one stage is configured on the movable support in a manner of being able to move relatively to the movable support, so that the at least one electrode is able to move relatively to the workpiece to be coated.

7. The coating apparatus of claim 6, wherein the at least one electrode is configured between adjacent stages.

8. The coating apparatus of claim 7, wherein each electrode between adjacent stages is configured with an orientation toward the stage.

9. The coating apparatus of claim 8, wherein adjacent two electrodes form a V-shaped structure, an opening of the V-shaped structure faces outwardly, and the adjacent two electrodes respectively face adjacent two stages correspondingly.

10. The coating apparatus of claim 6, wherein the electrode has a discharge surface, the movable support is provided with at least one conductive plate which is configured facing relatively to each electrode, wherein the conductive plate has a conductive surface, conductive surfaces of adjacent two conductive plates form an included angle, and conductive surfaces of adjacent two conductive plates and the discharge surface of the electrode which is configured facing the adjacent two conductive plates form a triangular discharge area.

11. The coating apparatus of claim 6, wherein the at least one electrode is configured on the inner side of a plurality of stages to serve as at least one inner electrode.

12. The coating apparatus of claim 6, wherein the at least one electrode is configured along the circumferential direction of the movable support and is configured between adjacent two stages to serve as at least one outer electrode.

13. The coating apparatus of claim 11, wherein the at least one electrode is configured along the circumferential direction of the movable support and is configured between adjacent two stages to serve as at least one outer electrode.

14. The coating apparatus of claim 6, wherein the movable support is configured on the reaction chamber body in a manner of being able to rotate around a first axis of the movable support center.

15. The coating apparatus of claim 8, wherein the stage is configured on the movable support in a manner of being able to rotate around a second axis of the stage center, and the second axis is configured on the circumferential side of a first axis, wherein the movable support is configured on the reaction chamber body in a manner of being able to rotate around the first axis of the movable support center.

16. The coating apparatus of claim 15, wherein the movable support device further comprises a stage support frame, the stage support frame is configured on the movable support in a manner of being able to rotate around the second axis, a plurality of stages are disposed on the stage support frame at intervals along the height direction, and the electrode is configured between adjacent two stage support frames.

17. The coating apparatus of any one of claims 1 to 16, wherein the coating apparatus further comprises a conductive unit, the conductive unit comprises a first conductive part and a second conductive part, the first conductive part is configured in the reaction chamber body, the second conductive part is configured on the movable support, the first conductive part is conductively coupled with the second conductive part, and the second conductive part is conductively coupled with the electrode, and
in response to the movable support rotating around the first axis relative to the reaction chamber body, the second conductive part is configured rotatable relative to the first conductive part and maintains conductive with the first conductive part, such that the electric energy from outside the reaction chamber can be transmitted from the first conductive part to the second conductive part, and thus to the electrode.

18. The coating apparatus of claim 17, wherein the movable support comprises an upper support and a lower support, the upper support is held above the lower support and forms a loading space, the second conductive part is configured on the upper support, and the first conductive part is pressed tightly and supported on the second conductive part.

19. The coating apparatus of any one of claims 6 to 15, wherein each stage comprises a stage transmission part, the movable support comprises a movable support engagement part, which operates as a gear to be engaged with the stage transmission part and to move relatively to the stage transmission part.

20. The coating apparatus of any one of claims 6 to 15, wherein each electrode comprises an electrode plate respectively, the movable support is provided with at least one conductive plate which is configured facing relatively to each electrode, adjacent two conductive plates form an included angle, and adjacent two conductive plates and electrode plate which is facing the two conductive plates form a triangular structure.

21. The coating apparatus of claim 14, wherein a plurality of electrodes are configured around the first axis in centro-symmetry.

22. The coating apparatus of claim 3 or claim 4, wherein the discharge surface of the at least one electrode is complanate or arc-shaped.

23. The coating apparatus of any one of claims 1 to 16, wherein the at least one electrode is arc-shaped.

24. The coating apparatus of any one of claims 1 to 16, wherein an electrode and a movable support have opposite polarities to each other, so that the electrode discharges toward the movable support.

25. The coating apparatus of any one of claims 1 to 16, wherein the movable support is grounded.

26. The coating apparatus of any one of claims 1 to 16, wherein the movable support is provided with a conductive surface matching the size of each electrode.

27. The coating apparatus of any one of claims 1 to 16, wherein each electrode comprises an electrode plate, and the movable support is provided with a conductive plate which is configured facing relatively to each electrode.

28. The coating apparatus of any one of claims 1 to 16, wherein the coating apparatus also comprises an electrode frame, the electrode frame is configured in the reaction chamber body in a manner of being able to move relatively to the reaction chamber body, and the electrode is configured on the electrode frame.

29. The coating apparatus of claim 28, wherein the electrode frame and the movable support are independent from each other.

30. The coating apparatus of claim 28, wherein the electrode frame and the movable support constitute an integrated structure, and the electrode frame constitutes a part of the movable support.

31. A movable electrode device which is applied in a coating apparatus, wherein the coating apparatus comprises a reaction chamber body, the movable electrode device comprises one or more electrodes, wherein the one or more electrodes are movable, which are configured in the reaction chamber body in a manner of being able to move relatively to the reaction chamber body.

32. The movable electrode device of claim 31, wherein the coating apparatus also comprises a movable support which is configured in the reaction chamber body in a manner of being able to move relatively to the reaction chamber body, the movable support is adapted to hold at least one workpiece to be coated which can move along with the movable support, an electrode is configured on the movable support.

33. The movable electrode device of claim 32, wherein the at least one electrode is configured in a circumferential direction of the movable support.

34. The movable electrode device of claim 32, wherein the at least one electrode has a discharge surface, wherein the discharge surface is configured with an orientation toward a central axis of the movable support.

35. The movable electrode device of claim 32, wherein the at least one electrode has a discharge surface, wherein the discharge surface is configured with an orientation toward the workpiece to be coated.

36. The movable electrode device of claim 32, wherein the at least one electrode is configured in a radial direction of the movable support.

37. The movable electrode device of claim 32, wherein the coating apparatus further comprises at least one stage which is configured on the movable support, the stage is adapted for holding the workpiece to be coated and the stage is configured on the movable support in a manner of being able to move relatively to the movable support, so that the electrode is able to move relatively to the workpiece to be coated.

38. The movable electrode device of claim 37, wherein the at least one electrode is configured between adjacent stages.

39. The movable electrode device of claim 38, wherein each electrode between adjacent stages is configured with an orientation toward the stage.

40. The movable electrode device of claim 39, wherein adjacent two electrodes form a V-shaped structure, an opening of the V-shaped structure faces outwardly, and the adjacent two electrodes respectively face adjacent two stages correspondingly.

41. The movable electrode device of claim 37, wherein the electrode has a discharge surface, the movable support is provided with at least one conductive plate which is configured facing relatively to each electrode, wherein the conductive plate has a conductive surface, conductive surfaces of adjacent two conductive plates form an included angle, and conductive surfaces of adjacent two conductive plates and the discharge surface of the electrode which is configured facing the adjacent two conductive plates form a triangular discharge area.

42. The movable electrode device of claim 37, wherein the at least one electrode is configured on the inner side of a plurality of stages to serve as at least one inner electrode.

43. The movable electrode device of claim 37, wherein the at least one electrode is configured along the circumferential direction of the movable support and is configured between adjacent two stages to serve as at least one outer electrode.

44. The movable electrode device of claim 42, wherein the at least one electrode is configured along the circumferential direction of the movable support and is configured between adjacent two stages to serve as at least one outer electrode.

45. The movable electrode device of claim 37, wherein the movable support is configured on the reaction chamber body in a manner of being able to rotate around a first axis of the movable support center.

46. The movable electrode device of claim 39, wherein the stage is configured on the movable support in a manner of being able to rotate around a second axis of the stage center, and the second axis is configured on the circumferential side of a first axis, wherein the movable support is configured on the reaction chamber body in a manner of being able to rotate around the first axis of the movable support center.

47. The movable electrode device of claim 44, wherein a plurality of electrodes are configured around a first axis in centro-symmetry, wherein the movable support is configured on the reaction chamber body in a manner of being able to rotate around the first axis of the movable support center.

48. The movable electrode device of claim 34, claim 35, or claim 41, wherein the discharge surface of the at least one electrode is complanate or arc-shaped.

49. The movable electrode device of any one of claims 32 to 40 and claims 42 to 46, wherein the at least one electrode is arc-shaped.

50. The movable electrode device of any one of claims 32 to 40 and claims 42 to 46, wherein the electrode and the movable support have opposite polarities to each other, so that the electrode discharges toward the movable support.

51. The movable electrode device of claim 49, wherein the movable support is grounded.

52. The movable electrode device of claim 49, wherein the movable support is provided with a conductive surface matching the size of each electrode.

53. The movable electrode device of claim 49, wherein each electrode comprises an electrode plate, and the movable support is provided with a conductive plate which is configured facing relatively to each electrode.

54. The movable electrode device of claim 31, wherein the coating apparatus also comprises a movable support, and the movable support is adapted to hold at least one workpiece to be coated which can move along with the movable support, wherein the movable electrode device also comprises an electrode frame, the electrode frame is configured in the reaction chamber body in a manner of being able to move relatively to the reaction chamber body, and the electrode is configured on the electrode frame.

55. The movable electrode device of claim 53, wherein the electrode frame and the movable support are independent from each other.

56. The movable electrode device of claim 53, wherein the electrode frame and the movable support constitute an integrated structure, and the electrode frame constitutes a part of the movable support.

57. A movable support device which is applied in a coating apparatus, wherein the coating apparatus comprises a reaction chamber body, and the movable support device comprises:
at least one electrode;
a movable support, wherein the movable support is movable relative to the reaction chamber body, and the at least one electrode is configured on the movable support in a manner of being able to move along with the movable support; and
at least one stage, wherein the at least one stage is configured on the movable support in a manner of being able to move along with the movable support.

58. The movable support device of claim 57, wherein the movable support is configured on the reaction chamber body in a manner of being able to rotate around a first axis, the at least one electrode is configured on the movable support in a manner of being able to move along with the movable support, the stage is configured on the movable support in a manner of being able to rotate along with the movable support around the first axis, and each stage is held on the movable support in a manner of being able to rotate around a second axis.

59. The movable support device of claim 57, wherein the electrode has a discharge surface, the discharge surface is configured toward a central axis of the movable support; or
the electrode has a discharge surface, the discharge surface is configured toward the stage, and the electrode is held on the circumferential side of the stage.

60. The movable support device of claim 58, wherein the at least one electrode is held at a circumferential position of the movable support.

61. The movable support device of claim 58, wherein the movable support device further comprises a stage support frame, wherein the stage support frame is configured on the movable support in a manner of being able to rotate around the second axis; and
a plurality of stages are disposed on the stage support frame at intervals along the height direction, wherein the electrode is configured between adjacent two stage support frames.

62. The movable support device of claim 59, the movable support device further comprises a stage support frame, wherein the stage support frame is configured on the movable support in a manner of being able to rotate around a second axis;
a plurality of stages are disposed on the stage support frame at intervals along the height direction, wherein the electrode is configured between adjacent two stage support frames.

63. The movable support device of claim 59, wherein the discharge surface of the at least one electrode is complanate or arc-shaped.

64. The movable support device of claim 61, wherein the at least electrode is arc-shaped.

65. The movable support device of claim 63, wherein the stage is a circular stage, and the radian of the electrode is the same as the radian of the circular stage.

66. The movable support device of claim 64, wherein the second axis constitutes a central axis of the stage.

67. The movable support device of claim 61, wherein there are at least two electrodes configured symmetrically around the first axis.

68. The movable support device of claim 61, wherein there are at least two electrodes are configured symmetrically around the second axis.

69. The movable support device of claim 61, wherein the stage support frame comprises an upper support part, a lower support part and a side support part;
the upper support part is supported on the lower support part through the side support part, the second axis passes through the upper support part, the stage and the lower support part, and the at least one electrode is configured outside the side support part.

70. The movable support device of claim 61, wherein at least two stages support frames are symmetrically configured around the first axis, and at least two electrodes are configured on the inner side of the stage support frame.

71. The movable support device of any of claims 57 to 70, wherein the electrode and the movable support have opposite polarities to each other, so that the electrode discharges toward the movable support.

72. The movable support device of claim 71, wherein the movable support is grounded.

73. The movable support device of claim 71, wherein each electrode comprises an electrode plate, and the movable support is provided with a conductive plate which is configured facing relatively to each electrode.

74. The movable support device of any of claims 58 to 70, further comprising:
a conductive unit, wherein the conductive unit comprises a first conductive part and a second conductive part, the first conductive part is configured in the reaction chamber body, the second conductive part is configured on the movable support;
the first conductive part is conductively coupled with the second conductive part, the second conductive part is conductively coupled with the electrode; and
when the movable support rotates around the first axis relative to the reaction chamber body, the second conductive part is able to rotate relative to the first conductive part and maintains conductive with the first conductive part, such that the electric energy from outside the reaction chamber can be transmitted from the first conductive part to the second conductive part, and thus to the electrode.

75. The movable support device of claim 74, wherein the movable support comprises an upper support and a lower support, the upper support is held above the lower support and forms a loading space, the second conductive part is configured on the upper support, and the first conductive part is pressed tightly and supported on the second conductive part.

76. The movable support device of claim 75, wherein each stage comprises a stage transmission part, and the movable support comprises a movable support engagement part, which operates as a gear to be engaged with the stage transmission part and to move relatively to the stage transmission part.

77. The movable support device of any of claims 57 to 63, wherein each electrode comprises an electrode plate respectively, the movable support is provided with at least one conductive plate which is configured facing relatively to each electrode, adjacent two conductive plates form an included angle, and the adjacent two conductive plates and an electrode which is configured facing the adjacent two conductive plates form a triangular structure.

78. An electrode discharge method, comprising:
when at least one workpiece to be coated moves along with a movable support relative to a reaction chamber body, at least one electrode which is movable relative to the reaction chamber body discharging relative to the movable support in the reaction chamber body.

79. The electrode discharge method of claim 78, further comprising: driving the electrode and the workpiece to be coated to move together with the movable support.

80. The electrode discharge method of claim 79, further comprising: generating relative movement between the electrode and the workpiece to be coated.

81. The electrode discharge method of claim 78, wherein the at least one electrode is configured in a circumferential direction of the movable support.

82. The electrode discharge method of claim 78, wherein the at least one electrode has a discharge surface, and the discharge surface is configured with an orientation toward the central axis of the movable support.

83. The electrode discharge method of claim 78, wherein the at least one electrode has a discharge surface, and the discharge surface is configured with an orientation toward the workpiece to be coated.

84. The electrode discharge method of claim 78, wherein the at least one electrode is configured in a radial direction of the movable support.

85. The electrode discharge method of claim 80, comprising: driving at least one stage carrying the workpiece to be coated to move by the movable support.

86. The electrode discharge method of claim 85, wherein the at least one electrode is configured between adjacent stages.

87. The electrode discharge method of claim 86, wherein each electrode between the adjacent stages is configured with an orientation toward the stage.

88. The electrode discharge method of claim 87, wherein adjacent two electrodes form a V-shaped structure, an opening of the V-shaped structure faces outwardly, and the adjacent two electrodes respectively face adjacent two stages correspondingly.

89. The electrode discharge method of claim 85, wherein the electrode has a discharge surface, the movable support is provided with at least one conductive plate which is configured facing relatively to each electrode, wherein the conductive plate has a conductive surface, conductive surfaces of adjacent two conductive plates form an included angle, and conductive surfaces of adjacent two conductive plates and the discharge surface of the electrode which is configured facing the adjacent two conductive plates form a triangular discharge area.

90. The electrode discharge method of claim 85, wherein the at least one electrode is configured on the inner side of a plurality of stages to serve as at least one inner electrode.

91. The electrode discharge method of claim 85, wherein the at least one electrode is configured along the circumferential direction of the movable support and is configured between adjacent two stages to serve as at least one outer electrode.

92. The electrode discharge method of claim 91, wherein the at least one electrode is configured along the circumferential direction of the movable support and is configured between adjacent two stages to serve as at least one outer electrode.

93. The electrode discharge method of claim 85, comprising: driving the stage to rotate around a first axis of the movable support center and around a second axis of the stage center, and driving the electrode to rotate around the first axis.

94. The electrode discharge method of claim 93, wherein a plurality of electrodes are configured around the first axis in centro-symmetry, and the movable support is configured on the reaction chamber body in a manner of being able to rotate around the first axis of the movable support center.

95. The electrode discharge method of claim 82, claim 83 or claim 89, wherein the discharge surface of the at least one electrode is complanate or arc-shaped.

96. The electrode discharge method of any one of claims 78 to 94, wherein the at least electrode is arc-shaped.

97. The electrode discharge method of any one of claims 78 to 94, wherein the electrode and the movable support have opposite polarities to each other, so that the electrode discharges toward the movable support.

98. The electrode discharge method of claim 96, wherein the movable support is grounded.

99. The electrode discharge method of claim 96, wherein the movable support is provided with a conductive surface matching the size of each electrode.

100. The electrode discharge method of claim 96, wherein each electrode comprises an electrode plate, and the movable support is provided with a conductive plate which is configured facing relatively to each electrode.

101. The electrode discharge method of claim 100, wherein an electrode frame and the movable support are independent from each other.

102. The electrode discharge method of claim 100, wherein an electrode frame and the movable support constitute an integrated structure, and the electrode frame constitutes a part of the movable support.
